(19) Europäisches Patentamt
European Patent Office
Office européen des brevets

(11) **EP 3 786 321 A2**

(12) **EUROPÄISCHE PATENTANMELDUNG**

(43) Veröffentlichungstag:
**03.03.2021 Patentblatt 2021/09**

(51) Int Cl.:
*C30B 25/16* (2006.01)    *C30B 29/38* (2006.01)

(21) Anmeldenummer: **20192907.2**

(22) Anmeldetag: **26.08.2020**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **27.08.2019   DE 102019212821**
**02.04.2020   DE 102020204294**

(71) Anmelder:
• **Albert-Ludwigs-Universität Freiburg**
**79098 Freiburg (DE)**
• **FRAUNHOFER-GESELLSCHAFT zur Förderung der angewandten Forschung e.V.**
**80686 München (DE)**

(72) Erfinder:
• **Leone, Stefano**
**79108 Freiburg (DE)**
• **Manz, Christian**
**79108 Freiburg (DE)**
• **Menner, Hanspeter**
**79108 Freiburg (DE)**
• **Wiegert, Joachim**
**79108 Freiburg (DE)**
• **Ligl, Jana**
**79108 Freiburg (DE)**

(74) Vertreter: **Friese Goeden Patentanwälte PartGmbB**
**Widenmayerstraße 49**
**80538 München (DE)**

(54) **VERFAHREN UND VORRICHTUNG ZUR HERSTELLUNG EINER SCHICHT UND DAMIT VERSEHENES SUBSTRAT**

(57)    Die Erfindung betrifft ein Verfahren zur Herstellung einer Schicht auf einem Substrat durch metallorganische Gasphasenepitaxie, die mindestens eine Verbindungen der Formel $M^1_a M^2_{1-a} N$ enthält oder daraus besteht, wobei $M^1$ für ein Element der Gruppe 13 des Periodensystems der Elemente und $M^2$ für ein Element der Gruppe 3 oder der Gruppe der Actinoide oder der Gruppe der Lanthanoide des Periodensystems der Elemente stehen und $0,01 \leq a < 0,99$ gewählt ist, wobei ein erster Prekursor mit einem Molarfluss ($\dot{n}$) von mindestens $10^{-6}$ mol/min in eine Reaktionskammer (1) für die metallorganische Gasphasenepitaxie geleitet wird, welcher $M^2$ enthält oder daraus besteht. Weiterhin wird eine Vorrichtung zur Durchführung des Verfahrens angegeben und ein nach diesem Verfahren beschichtetes Substrat.

Fig. 8

EP 3 786 321 A2

**Beschreibung**

Die Erfindung betrifft ein Verfahren zur Herstellung einer Schicht auf einem Substrat durch metallorganische Gasphasenepitaxie (MOCVD bzw. MOVPE), die mindestens eine Verbindung der Summenformel $M^1_a M^2_{1-a} N$ enthält oder daraus besteht, wobei $M^1$ für ein Element der Gruppe 13 des Periodensystems der Elemente und $M^2$ für ein Element der Gruppe 3 oder der Gruppe der Actinoide oder der Gruppe der Lanthanoide des Periodensystems der Elemente stehen und $0 \leq a < 1$ gewählt ist. Ferner betrifft die Erfindung eine nach diesem Verfahren hergestellte Schicht, einen Wafer mit dieser Schicht, die Verwendung dieser Schicht in elektronischen Bauelementen sowie eine Vorrichtung zur Herstellung von solchen Schichten.

Bauelemente auf der Basis von Nitriden des Scandiums werden als nächste Generation der Leistungselektronik oder der Optoelektronik angesehen. Mit AlScN in Kombination mit weiteren, heteroepitaktisch abgeschiedenen binären oder ternären Gruppe-13-Nitriden können Transistoren mit hoher Elektronenbeweglichkeit (HEMT) mit hoher Leistung, höherer Grenzfrequenz und/oder hoher Effizienz erhalten werden.

Nach dem Stand der Technik können AlScN-Schichten mittels Sputtern hergestellt werden. Diese bekannten Schichten sind sämtlich polykristallin und weisen auch keine glatten Oberflächen auf, so dass keine Halbleiterheterostrukturen mit definierten Grenzflächen erzeugt werden können. Daher ist das bekannte, durch Sputtern erhältliche Material nicht zur Herstellung mikroelektronischer Bauelemente wie Transistoren oder optoelektronischen Bauelementen geeignet.

Alternativ zeigt der Stand der Technik, $Al_a Sc_{1-a} N$ mittels Molekularstrahlepitaxie (MBE) herzustellen. Mit diesem Verfahren können zwar hohe Sc-Anteile in der ternären Verbindung erhalten werden. Auch die Kristallqualität ist hinreichend gut für die Herstellung mikroelektronischer Bauelemente. Allerdings ist das Verfahren aufwändig und für die Herstellung großer Mengen des Materials für den Massenmarkt nicht tauglich. Das Verfahren hat sich zwar in Forschung und Entwicklung etabliert, allerdings sind die Wachstumsraten für industrielle Prozesse zu gering.

C. Saidi et al.: "Growth of Scandium-doped GaN by MOVPE". Superlattices and Microstructures, 60, 2013, 120-128 beschreiben das Wachstum von Scandium-dotierten GaN durch MOVPE. Ferner beschreiben D.D. Koleske et al. (Sandia Report, 2009) die Herstellung von ScGaN- und YGaN-Schichten durch MOCVD. Allerdings wird gemäß der Lehre beider Veröffentlichungen nur ein Sc-Anteil von etwa $1 \cdot 10^{18}$ at./cm$^3$ erreicht. Bei diesen bekannten Schichten handelt es sich um Sc-dotiertes GaN und nicht um eine ternäre $Al_a Sc_{1-a} N$ Verbindung.

In der chinesischen Patentveröffentlichung CN 108899403 A wird die Herstellung von ScAlN/AlGaN-basierenden p-dotierten Mehrschichtsystemen für LED durch MOCVD erwähnt. Allerdings enthält die Patentschrift keine nacharbeitbare technische Lehre. Das einzige in den Figuren offenbarte Ausführungsbeispiel verwendet $In_x Ga_{1-x} N / Al_z Ga_{1-z} N$-Übergitter als aktive Halbleiterschichten. Verfahrensparameter, welche zur Herstellung von $Al_a Sc_{1-a} N$-Schichten verwendet werden könnten, sind in dieser chinesischen Patentveröffentlichung nicht in einer für den Fachmann nacharbeitbaren Art beschrieben.

Ausgehend vom Stand der Technik liegt der vorliegenden Erfindung somit die Aufgabe zugrunde, ein reproduzierbares und für die industrielle Produktion geeignetes Herstellungsverfahren für hochwertige $M^1_a M^2_{1-a} N$-Schichten, anzugeben, bei welchem $M^2$ aus der 3. Gruppe des Periodensystems gewählt ist und mit welchem ternäre oder quaternäre Verbindungen bzw. Legierungen und nicht nur eine Dotierung einer binären oder ternären Verbindung erhalten werden. Ferner soll eine dazu geeignete Vorrichtung bereitgestellt werden.

Die Aufgabe wird erfindungsgemäß durch ein Verfahren nach Anspruch 1, ein Substrat mit zumindest einer Schicht nach Anspruch 9, sowie eine Vorrichtung nach Anspruch 11 gelöst. Vorteilhafte Weiterbildungen der Erfindung finden sich in den Unteransprüchen.

In einigen Ausführungsformen der Erfindnug betrifft diese ein Verfahren zur Herstellung einer Schicht auf einem Substrat durch metallorganische Gasphasenepitaxie, welche mindestens eine Verbindungen der Formel $M^1_a M^2_{1-a} N$ enthält oder daraus besteht, wobei $M^1$ für ein Element der Gruppe 13 des Periodensystems der Elemente steht und $M^2$ ausgewählt ist aus Scandium oder Yttrium oder Erbium oder Europium und $0,01 \leq a < 0,99$ gewählt ist, dadurch gekennzeichnet, dass zumindest zeitweise ein erster Prekursor, welcher $M^2$ enthält oder daraus besteht, mit einem Molarfluss (n) von mindestens $1 \cdot 10^{-6}$ mol/min in eine Reaktionskammer (1) für die metallorganische Gasphasenepitaxie geleitet wird.

Erfindungsgemäß wird ein Verfahren zur Herstellung zumindest einer Schicht auf einem Substrat durch metallorganische Gasphasenepitaxie (MOVPE bzw. MOCVD) vorgeschlagen, wobei die Schicht mindestens eine Verbindung der Summenformel $M^1_a M^2_{1-a} N$ enthält oder daraus besteht, wobei $M^1$ für ein Element der Gruppe 13 des Periodensystems der Elemente und $M^2$ für ein Element der Gruppe 3 oder der Gruppe der Actinoide oder der Gruppe der Lanthanoide des Periodensystems der Elemente stehen und $0,01 \leq a < 0,99$ gewählt ist. Während der Durchführung des Verfahrens wird zumindest zeitweise ein erster Prekursor, welcher $M^2$ enthält oder daraus besteht, mit einem Molarfluss von mindestens $10^{-6}$ mol/min in eine Reaktionskammer für die metallorganische Gasphasenepitaxie geleitet. Dieses Merkmal hat die Wirkung, dass die Verbindung mit der der Summenformel $M^1_a M^2_{1-a} N$ auch mit höherem Gehalt an $M^2$ hergestellt werden kann, als dies nach dem Stand der Technik mit diesen Verfahren möglich ist.

Erfindungsgemäß wird weiterhin eine Vorrichtung zur Herstellung zumindest einer Schicht mittels MOCVD oder MOVPE vorgeschlagen, welche zumindest eine Reaktionskammer und zumindest einen beheizbaren Substrathalter zur Aufnahme des zu beschichtenden Substrates und zumindest einem Gaseinlass enthält. Die Vorrichtung enthält weiterhin zumindest einen Bubbler, welcher über eine Leitung mit dem Gaseinlass der Reaktionskammer verbunden ist. Der Bubbler ist mit einer Heizeinrichtung gekoppelt, mit welcher der Bubbler auf mehr als etwa 90°C oder mehr als etwa 140°C erwärmt werden kann. Weiterhin weist die Vorrichtung eine Rohrbegleitheizung auf, mit welcher die Leitung auf mehr als etwa 90°C oder mehr als etwa 140°C erwärmt werden kann.

Für die Zwecke der vorliegenden Beschreibung bezeichnet ein Element der Gruppe 13 ein Element der Bor-Gruppe bzw. der Erdmetalle, also insbesondere Ga, In und/oder Al. Dementsprechend bezeichnet ein Element der 3. Gruppe ein Element der Scandiumgruppe oder ein Element aus der Gruppe der Lanthanoide oder der Actinoide, soweit diese ausreichend stabil sind. Die Nummerierung der Gruppen des Periodensystems wird in der vorliegenden Beschreibung mit arabischen Ziffern 1 bis 18 vorgenommen und folgt damit der gültigen IUPAC-Konvention.

In einigen Ausführungsformen der Erfindung ist die Schicht, wie sie vorstehend definiert wurde, eine Legierung. Die erfindungsgemäße Schicht unterscheidet sich daher von bekannten Schichten, welche ein Gruppe-13-Nitrid enthalten oder daraus bestehen und welche mit Scandium dotiert sind. Ferner kann die Schicht eine Epitaxieschicht sein. Das Schichtmaterial ist somit im Wesentlichen einkristallin, anders als Schichten, welche im Sputterverfahren hergestellt wurden und dadurch polykristallin sind.

Erfindungsgemäß wurde erkannt, dass mittels eines Molarflusses von mehr als etwa $10^{-6}$ mol/min des ersten Prekursors Schichten hoher Kristallqualität und mit einem hohen $M^2$-Gehalt (1-a) größer als etwa 0,01 oder größer als etwa 0,05 oder größer als etwa 0,1 oder größer als etwa 0,2 oder größer als etwa 0,3 mittels MOCVD oder MOVPE erhalten werden können.

Der zumindest eine erste Prekursor kann fest oder flüssig sein. Er kann einen Dampfdruck von kleiner oder gleich etwa 0,1 mmHg bzw. etwa 0,13 mbar bei Raumtemperatur aufweisen.

In einigen Ausführungsformen wird als erster Prekursor bzw. Ausgangsstoff für das zumindest eine Metall $M^2$ der 3. Gruppe zumindest eine metallorganische Verbindung verwendet. Diese metallorganische Verbindung kann in einigen Ausführungsformen der Erfindung aus zumindest einem Bubbler zugeführt werden. Der Aufbau eines solchen Bubblers entspricht dem einer Gaswaschflasche. Im Bubbler bildet sich ein gesättigter Dampf über der Flüssigkeit oder dem Feststoff. Wird der Bubbler von einem Trägergas durchflossen, wird die metallorganische Verbindung in die Reaktionskammer transportiert, in der dann die Abscheidung auf einem Substrat erfolgt. Das Trägergas kann ausgewählt sein aus Wasserstoff oder Stickstoff oder einem Inertgas, beispielsweise einem Edelgas.

In einigen Ausführungsformen der Erfindung wird der den ersten Prekursor für $M^2$ enthaltende Bubbler auf eine Temperatur von mehr als etwa 90°C erwärmt. In einigen Ausführungsformen der Erfindung kann der den ersten Prekursor enthaltende Bubbler auf etwa 120°C bis etwa 200°C erwärmt werden. In anderen Ausführungsformen der Erfindung kann der den ersten Prekursor enthaltende Bubbler auf etwa 150°C bis etwa 200° erwärmt werden. In wiederum anderen Ausführungsformen der Erfindung kann der den ersten Prekursor enthaltende Bubbler auf etwa 150°C bis etwa 175°C erwärmt werden. Auf diese Weise kann der Molarfluss von mehr als $10^{-6}$ mol/min erreicht werden, welcher es ermöglicht, die entsprechend großen Mengen an $M^2$ in die aufzuwachsende Schicht einzubauen. Hierzu kann eine Heizeinrichtung vorhanden sein, welche mittels eines Wärmeträgermediums und/oder einer elektrischen Widerstandsheizung den Bubbler auf die gewünschte Temperatur bringt. Die Heizeinrichtung kann mit einer Steuerung oder einer Regelung versehen sein, um Abweichungen vom Sollwert zu reduzieren oder zu vermeiden. Die Heizeinrichtung kann ein Bad mit einem flüssigen Wärmeträgermedium enthalten oder daraus bestehen. Das Wärmeträgermedium kann ausgewählt sein aus Wasser oder einem flüssigen Metall oder einer Legierung oder einem Thermoöl. In anderen Ausführungsformen der Erfindung kann die Heizeinrichtung einen Wärmeschrank enthalten oder daraus bestehen, in dessen Innenraum der Bubbler eingebracht ist. Der Innenraum des Wärmeschrankes kann Luft oder zumindest ein Schutzgas enthalten. Der Druck im Innenraum des Wärmeschrankes kann Atmosphärendruck betragen oder höher oder niedriger gewählt sein.

Für die Durchführung eines MOCVD- oder MOVPE-Verfahrens sind die Bubbler, in welchen die Prekursoren enthalten sind, jeweils mit einer Leitung mit der Reaktionskammer verbunden, in welcher die Abscheidung der Schicht auf dem Substrat erfolgt. In einigen Ausführungsformen des erfindungsgemäßen Verfahrens wird zumindest die Temperatur der Leitung, welche den den ersten Prekursor enthaltenden Bubbler mit der Reaktionskammer verbindet, auf eine Temperatur von mehr als etwa 90°C erwärmt. In einigen Ausführungsformen der Erfindung kann diese Leitung auf etwa 120°C bis etwa 200°C erwärmt werden. In anderen Ausführungsformen der Erfindung kann diese Leitung auf etwa 150°C bis etwa 200° erwärmt werden. In wiederum anderen Ausführungsformen der Erfindung kann diese Leitung auf etwa 150°C bis etwa 175°C erwärmt werden. In wiederum anderen Ausführungsformen der Erfindung kann diese Leitung auf etwa 120°C bis etwa 160°C erwärmt werden. Die Temperatur der Leitung kann in einigen Ausführungsformen so eingestellt werden, dass sie der Temperatur des Bubblers mit einer Abweichung von +0°C bis +10°C oder von +0°C bis +5°C oder von +0°C bis +30°C oder von +0°C bis +50°C oder von +5°C bis +50°C. entspricht. Hierzu kann eine Rohrbegleitheizung vorhanden sein, welche mittels eines Wärmeträgermediums und/oder einer elektrischen Widerstandsheizung die Leitung auf die gewünschte Temperatur bringt. Die Rohrbegleitheizung kann mit einer Steuerung oder einer Regelung versehen sein, um Abweichungen vom Sollwert zu reduzieren oder zu vermeiden.

In einigen Ausführungsformen der Erfindung kann der Druck in der Leitung auf mehr als etwa 0,15 bar eingestellt werden. In anderen Ausführungsformen der Erfindung kann der Druck in der Leitung auf etwa 0,15 bar bis etwa 0,3 bar eingestellt werden. In wiederum anderen Ausführungsformen der Erfindung kann der Druck in der Leitung auf etwa 0,17 bar bis etwa 0,26 bar eingestellt werden. In wiederum anderen Ausführungsformen der Erfindung kann der Druck in der Leitung auf etwa 0.05 bis etwa 1 bar eingestellt werden. Damit kann der Gehalt an $M^2$ in den Schichten in der gewünschten Menge sichergestellt werden.

In bekannten Vorrichtungen zur Durchführung eines MOCVD- oder MOVPE-Verfahrens sind in den Leitungen, welche die Bubbler mit der Reaktionskammer verbinden, in der Regel Massenflussregler und/oder Druckregler und/oder Ventile und/oder Gasinjektionssysteme vorhanden, die eine präzise Steuerung der der Reaktionskammer zugeführten Gasmenge der Prekursoren ermöglichen und so eine hohe Reproduzierbarkeit des epitaktischen Wachstumsprozesses gewährleisten. Da in einigen Ausführungsformen der Erfindung der Bubbler und gegebenenfalls die entsprechende Leitung für den ersten Prekursor auf eine Temperatur von mehr als etwa 90°C oder mehr als 120°C erwärmt wird, können bekannte Komponenten nicht eingesetzt werden. Es sind derzeit keine Komponenten bekannt, welche Temperaturen über 70°C standhalten. Erfindungsgemäß wird daher vorgeschlagen, mechanische oder pneumatische Ventile einzusetzen, welche keine elektronischen Komponenten aufweisen, welche durch hohe Temperaturen beeinträchtigt werden. Hierdurch kann der Totaldruck $p_{total}$ innerhalb des Bubblers gemessen oder über ein Federventil auf einen oberen Grenzwert eingestellt werden. Zusammen mit dem Fluss des Trägergases $\dot{V}$ und dem Partialdruck $p_{sc}$ des Metalls kann der Molarfluss $\dot{n}$ des ersten Prekursors gemessen oder auch geregelt werden, ohne dass ein Massenflussregler in der heißen Zone des Bubblers oder der Leitung eingesetzt werden muss. Hierzu kann fallweise auch ein Rückschlagventil oder ein oneumatisches Ventil in der Leitung vorhanden sein.

Die Bestimmung des Molarflusses $\dot{n}$ des ersten Prekursors kann in einigen Ausführungsformen der Erfindung durch folgende Formel erfolgen:

$$\dot{n} = \frac{p_{total} \cdot \dot{V} \cdot \dfrac{p_{sc}}{p_{total}}}{R \cdot T}$$

Hierbei bezeichnet $\dot{V}$ den Fluss des Trägergases, $p_{sc}$ den Partialdruck des Metalls $M^2$ der 3. Gruppe, $p_{total}$ den Totaldruck innerhalb des Bubblers, welcher sich aus dem Dampfdruck des Precursors und dem druck des Trägergases zusammensetzt, $T$ die Temperatur des Bubblers und $R$ die universelle Gaskonstante. Die Temperatur $T$ des Bubblers und der Fluss $\dot{V}$ des Trägergases kann gemessen und/oder durch zugeordnete Steuer- oder Regeleinrichtungen kontrolliert werden. Der Totaldruck $p_{total}$ kann gemessen werden, beispielsweise durch ein kapazitives Manometer oder ein Federmanometer. Der Partialdruck $p_{sc}$ des Metalles $M^2$ der 3. Gruppe kann aus der Temperatur $T$ des Bubblers bestimmt werden, wenn für den verwendeten Prekursor die Dampfdruckkurve bekannt ist oder bestimmt wurde. Das Bestimmen der Dampfdruckkurve kann in an sich bekannter Weise experimentell erfolgen oder es können näherungsweise Daten einer ähnlichen Verbindung verwendet werden.

In einigen Ausführungsformen weist zumindest eine Leitung, welche einen Bubbler mit der Reaktionskammer verbindet, weiterhin ein Druckmessgerät auf. Mit dem Druckmessgerät kann der Druck des Prekursors in der Leitung gemessen und gegebenenfalls durch Regelung des Trägergasflusses auf einen vorgebbaren Sollwert geregelt werden.

In einigen Ausführungsformen weist zumindest eine Leitung, welche einen Bubbler mit der Reaktionskammer verbindet, zumindest ein Rückschlagventil auf. Mit dem Rückschlagventil wird eine Kontamination durch Rückfluss von anderen Gasen, beispielsweise Trägergas und andere Prekursoren, in die Leitung bzw. den Bubbler für den ersten Prekursor verhindert.

In einigen Ausführungsformen der Erfindung ist $M^1$ ausgewählt aus Aluminium oder Indium oder Gallium. In einigen Ausführungsformen der Erfindung ist $M^2$ ausgewählt aus Sc oder Y oder Er oder Eu. Das erfindungsgemäße Verfahren ist damit geeignet, entsprechende Schichten oder Mehrfachschichtsysteme für die Opto- oder Leistungselektronik herzustellen. Beispiele für die Verbindungen der Formel $M^1_a M^2_{1-a} N$ sind ScN, $Al_a Sc_{1-a} N$, $Ga_a Sc_{1-a} N$, $Al_a Y_{1-a} N$, $Al_a Eu_{1-a} N$ und $Al_a Er_{1-a} N$, wobei a wie vorstehend gewählt ist.

In einigen Ausführungsformen kann die erfindungsgemäß hergestellte Schicht weiterhin ein Metall $M^3$ enthalten, welches aus der der 3. Gruppe oder der 13. Gruppe des Periodensystems gewählt ist, so dass die Schicht mindestens eine Verbindungen der Summenformel $M^1_a M^3_b M^2_{1-a-b} N$ enthält oder daraus besteht, wobei $M^1$ für ein Element der Gruppe 13 des Periodensystems der Elemente und $M^2$ für ein Element der Gruppe 3 oder der Gruppe der Actinoide oder der Gruppe der Lanthanoide des Periodensystems der Elemente stehen und $M^3$ für eines der vorhergehend genannten Elemente steht und $0 \leq a < 0,99$ gewählt ist und $0 \leq b < 0,99$ gewählt ist, wobei 1-a-b > 0 oder 1-a-b > 0,05 oder 1-a-b > 0,1 ist. Beispielsweise kann diese Schicht GaScYN oder InGaScN enthalten oder daraus bestehen.

Für das erfindungsgemäße Verfahren können als Substrate jegliche unbeschichtete oder bereits beschichtete Substrate bzw. Wafer verwendet werden, die für die vorstehend und nachfolgend angegebenen Verwendungen geeignet sind. Beispiele dafür sind Saphir, Silicium, Aluminiumnitrid, Galiumnitrid und/oder Siliciumcarbid.

Bei Abscheidung der Schicht kann das Substrat beheizt werden, beispielsweise auf eine Temperatur von etwa 700°C bis etwa 1400°C. In anderen Ausführungsformen kann das Substrat auf eine Temperatur von etwa 900°C bis etwa 1300°C geheizt werden. In wiederum anderen Ausführungsformen kann das Substrat auf eine Temperatur von etwa 700°C bis etwa 1300°C geheizt werden. In weiteren anderen Ausführungsformen kann das Substrat auf eine Temperatur von etwa 1000°C bis etwa 1300°C geheizt werden.

Mit der MOCVD können epitaktische Schichten mit hoher kristalliner Qualität auch auf Wafern bzw. Substraten mit großem Durchmesser von mehr als 50 mm oder mehr als 75 mm oder mehr als 100 mm oder mehr als 150 mm erzeugt werden. Dabei kann $M^1_aM^3_bM^2_{1-a-b}N$, beispielsweise AlScN, mit einer Wachstumsrate von etwa 0,02 nm/s bis etwa 0,15 nm/s oder von etwa 0,01 nm/s bis etwa 0,5 nm/s erzeugt werden. Eine vollständige HEMT-Struktur lässt sich mit dem erfindungsgemäßen Verfahren in etwa 2,5 h bis etwa 4 h oder in etwa 2,75 h bis etwa 3,5 h erzeugen, im Gegensatz zu bekannten MBE-Verfahren, welche etwa 7 h bis etwa 8 h erfordern. Gleichwohl können, anders als bei der Sputterabscheidung, Schichten hoher Qualität erzeugt werden. Die Qualität der erzeugten Schichten kann durch die Linienbreite der Bragg-Reflexe im Omega-Scan bestimmt werden, welche für die erfindungsgemäß hergestellten Schichten zwischen etwa 0,01° und etwa 0,3° oder zwischen etwa 0,03° bis etwa 0,07° FWHM liegen kann.

Die Abscheidung kann mit dem erfindungsgemäß vorgeschlagenen Verfahren homoepitaktisch oder heteroepitaktisch erfolgen. Insbesondere können auch Mehrschichtsysteme bzw. Übergitter aus Schichten unterschiedlicher Zusammensetzung erzeugt werden, welche jeweils eine unterschiedliche binäre oder ternäre oder quaternäre Verbindung von zumindest einem Element der Gruppe 13 und Stickstoff enthalten oder daraus bestehen. In einigen Ausführungsbeispielen der Erfindung können Multischichten bzw. Heteroübergänge zumindest zwei verschiedene Verbindungen enthalten, welche jeweils in Wurtzit-Struktur kristallisieren und unterschiedliche Bandlückenenergie aufweisen. Beispielsweise können Multischichten bzw. Schichtsysteme aus GaN/AlScN oder InGaN/AlScN oder GaN/AlYN oder AlGaN/AlScN oder AlGaN/AlYN erzeugt werden, an deren Grenzflächen sich ein zweidimensionales Elektronengas ausbilden kann.

In einigen Ausführungsformen der Erfindung ist es möglich, die Schichten in einer Reaktionskammer auf mehreren Substraten parallel zu wachsen. Hierdurch kann der Durchsatz erhöht werden.

In einigen Ausführungsformen der Erfindung kann der Druck in der Reaktionskammer bei der Abscheidung der erfindungsgemäßen Schicht, welche $M^1_aM^3_bM^2_{1-a-b}N$ enthält oder daraus besteht, zwischen etwa 40 mbar und etwa 150 mbar betragen.In anderen Ausführungsformen der Erfindung kann der Druck in der Reaktionskammer bei der Abscheidung der erfindungsgemäßen Schicht, welche $M^1_aM^3_bM^2_{1-a-b}N$ enthält oder daraus besteht, zwischen etwa 10 mbar to 1013 mbar betragen.

In einigen Ausführungsformen der Erfindung kann der Parameter a so ausgewählt sein, dass $0,5 \leq a < 0,99$ oder $0,5 \leq a < 0,95$ gilt. In einigen Ausführungsformen der Erfindung kann der Parameter a so ausgewählt sein, dass gilt: $0,5 \leq a \leq 0,90$. In anderen Ausführungsformen der Erfindung kann der Parameter a so ausgewählt sein, dass gilt: $0,7 \leq a \leq 0,95$. In wiederum anderen Ausführungsformen der Erfindung kann der Parameter a so ausgewählt sein, dass gilt: $0,7 \leq a \leq 0,9$. In wiederum anderen Ausführungsformen der Erfindung kann der Parameter a so ausgewählt sein, dass gilt: $0,5 \leq a \leq 0,8$. In wiederum anderen Ausführungsformen der Erfindung kann der Parameter a so ausgewählt sein, dass gilt: $0,8 \leq a \leq 0,95$. Damit werden durch das erfindungsgemäße Verfahren entsprechend hohe Gehalte von $M^2$ erreicht, die für die moderne Leistungs- oder Optoelektronik von Bedeutung sind.

In einer Ausführungsform wird als erster Prekursor das entsprechende Metall $M^2$ verwendet, welches mit zwei oder mehreren Cyclopentadienyl-Ringen (Cp) koordiniert ist, beispielsweise $Cp_3Sc$. In einer anderen Ausführungsform wird als erster Prekursor das entsprechende Metall $M^2$ verwendet, welches mit einem Cyclopentadienyl-Ring (Cp) koordiniert ist. Einer oder mehrere der Cyclopentadienyl-Ringe können mit C1-C5-Alkylgruppen substituiert sein, insbesondere Methyl- oder n-Butyl. Einer oder mehrere der Cyclopentadienyl-Ringe können mit einem Element der Gruppe 17 substituiert sein, insbesondere Chlor. Diese Prekursoren haben den Vorteil eines höheren Dampfdrucks gegenüber analogen Molekülen, bei denen die Metallatome mit Akylverbindungen, wie Methyl oder Ethyl, koordiniert sind. Durch Substitution mit der vorstehenden C1-C5-Alkylgruppe wird der Dampfdruck erhöht. Für Scandium sind $Cp_3Sc$ oder das entsprechende Methyl-substituierte Cyclopentadienyl $(MeCp)_3Sc$ besonders geeignet. In anderen Ausführungsformen der Erfindung kann der Prekursor das Metall $M^2$ enthalten, welches mit Amidine- oder Guanidine-Liganden koordiniert ist, so wie $C_{21}H_{45}ScN_6$ (tris(N,N-di-prop-2-yl-formamidinato)scandium), oder jeder andere sauerstofffreie Ligand.

Die in der Schicht vorliegenden Elemente $M^1$ und N können in die Reaktionskammer in an sich für das MOCVD-Verfahren bekannter Weise eingeleitet werden. Beispielsweise kann der zweite Prekursor für Stickstoff ausgewählt sein aus Ammoniak, Hydrazin, Phenylhydrazin, Dimethylhydrazin und/oder Tertiärbutylamin. Beispielsweise kann der dritte Prekursor für $M^1$ Trimethylaluminium und/oder Triethylaluminium bzw. Trimethylgallium und/oder Triethylgallium enthalten oder daraus bestehen. Die Handhabung dieser Prekursoren ist dem Fachmann bekannt, beispielsweise aus der Herstellung von AlGaN-, GaN- und AlN-Schichten mittels MOCVD-Verfahren, so dass das erfindungsgemäße Verfahren in einfacher Weise umgesetzt werden kann.

Gegenstand der vorliegenden Erfindung ist ferner eine Schicht, wie sie nach dem erfindungsgemäßen Verfahren hergestellt werden kann, insbesondere eine solche Schicht auf einem Substrat bzw. Wafer und/oder als Teil eines Mehrschichtsystems bzw. einer Halbleiterheterostruktur. Die erfindungsgemäßen Schichten können Teil eines optoelektronischen Bauelementes und/oder eines elektronischen Bauelementes und/oder eines akustooptischen Bauelementes und/oder akustoelektronischen Bauelementes sein. In einigen Ausführungsformen der Erfindung kann zumindest eine erfindungsgemäße Schicht eine aktive Schicht eines HEMT oder einer LED oder eines Halbleiterlasers oder eines optischen Detektors sein. In einigen Ausführungsformen der Erfindung kann die nach dem erfindungsgemäßen Verfahren hergestellte Schicht eine Ätzstoppschicht sein.

In einigen Ausführungsformen der Erfindung ist die Rohrbegleitheizung so ausgestaltet, dass diese zumindest eine Rohrleitung enthält, welche die Leitung umgibt und welche dazu eingerichtet ist, von einem Wärmeträgermedium durchströmt zu werden. Auf diese Weise ist die Leitung in etwa konzentrisch zur Rohrleitung angeordnet, so dass das Wärmeträgermedium im Zwischenraum strömen und die Leitung homogen erwärmen kann. Dies sichert einen gleichmäßigen Temperaturverlauf der Leitung auch dann, wenn die Leitung aus Material mit schlechter Wärmeleitfähigkeit gefertigt ist, wie beispielsweise Glas oder Kunststoff oder Edelstahl. Sowohl die Leitung für den Prekursor als auch die Rohrleitung des Wärmeträgermediums kann als starres Rohr oder als flexibler Schlauch ausgeführt werden oder abschnittsweise in unterschiedlichen Ausführungen.

In einigen Ausführungsformen der Erfindung können Abstandshalter zwischen der Außenseite der Leitung und der Innenseite der Rohrleitung angeordnet sein. Dies verhindert Wärmebrücken, so dass die Wandung der Leitung gleichmäßig erwärmt wird und eine unerwünschte Kondensation des Prekursors in der Leitung verhindert oder reduziert wird.

In einigen Ausführungsformen der Erfindung kann das Wärmeträgermedium ausgewählt sein aus Wasser oder Wasserdampf oder einem Thermoöl. In einigen Ausführungsformen der Erfindung kann das Wärmeträgermedium mit einem Druck oberhalb des Umgebungsdruckes durch die Rohrleitung zirkulieren. Dies kann den Siedepunkt erhöhen, so dass die Rohrbegleitheizung mit höherer Temperatur betrieben werden kann. In einigen Ausführungsformen der Erfindung kann das Wärmeträgermedium mit einem Druck von etwa 950 mbar bis etwa 1400 mbar in der Rohrleitung strömen. In anderen Ausführungsformen der Erfindung kann das Wärmeträgermedium mit einem Druck von etwa 1000 mbar bis etwa 1300 mbar in der Rohrleitung strömen.

In einigen Ausführungsformen der Erfindung betrifft diese eine Vorrichtung, welche eine Mehrzahl von parallelen Bubblern enthält, welche jeweils eine Heizeinrichtung aufweisen ist, mit welcher der Bubbler (2) auf mehr als 90°C oder etwa 120°C bis etwa 200°C oder etwa 150°C bis etwa 200°C oder etwa 150°C bis etwa 175°C oder etwa 120°C bis etwa 160°C erwärmt werden kann. In einigen Ausführungsformen kann die die Mehrzahl paralleler Bubbler zwischen 2 und etwa 15 oder zwischen 2 und etwa 10 oder zwischen 2 und 6 betragen.

Nachfolgend soll die Erfindung anhand von Figuren ohne Beschränkung des allgemeinen Erfindungsgedankens näher erläutert werden. Dabei zeigt

Figur 1     einen beispielhaften Aufbau eines mit dem erfindungsgemäßen Verfahren erhältlichen Schichtsystems

Figur 2     zeigt eine SIMS-Analyse einer $Al_aSc_{1-a}N$-Schicht, die auf einem $GaN/Al_2O_3$-Wafer aufgewachsen wurde, wobei der Parameter a = 0,705 beträgt.

Figur 3     zeigt ein optisches Mikroskopie-Bild einer $Al_{0,775}Sc_{0,225}N$-Epitaxieschicht.

Figur 4     zeigt ein optisches Mikroskopie-Bild einer $Al_{0,8}Sc_{0,2}N$-Epitaxieschicht.

Figur 5     zeigt eine AFM-Analyse einer $Ga_{0,999}Sc_{0,001}N$-Epitaxieschicht:
Fläche 10 x 10 $\mu m^2$ mit RMS = 0,33 nm (rechts);
Fläche 2 x 2 $\mu m^2$ mit RMS = 0,15 nm (links).

Figur 6     zeigt eine AFM-Analyse einer $Al_{0,887}Sc_{0,113}N$-Epitaxieschicht:
Fläche 10 x 10 $\mu m^2$ mit RMS = 0,33 nm (rechts);
Fläche 2 x 2 $\mu m^2$ mit RMS = 0,32 nm (links).

Figur 7     zeigt eine HRXRD-Analyse einer 300 nm dicken $Al_{0,8}Sc_{0,2}N$-Epitaxieschicht, die auf einem $GaN/Al_2O_3$-Substrat abgeschieden ist.

Figur 8     zeigt ein Blockdiagramm einer erfindungsgemäßen Vorrichtung in einer ersten Ausführungsform.

Figur 9     zeigt eine erfindungsgemäße Quelle in einer zweiten Ausführungsform, welche einen Molarfluss (n) von

mindestens $10^{-6}$ mol/min für einen Prekursor erzeugen kann.

Figur 10    zeigt ein Blockdiagramm einer erfindungsgemäßen Vorrichtung in einer zweiten Ausführungsform.

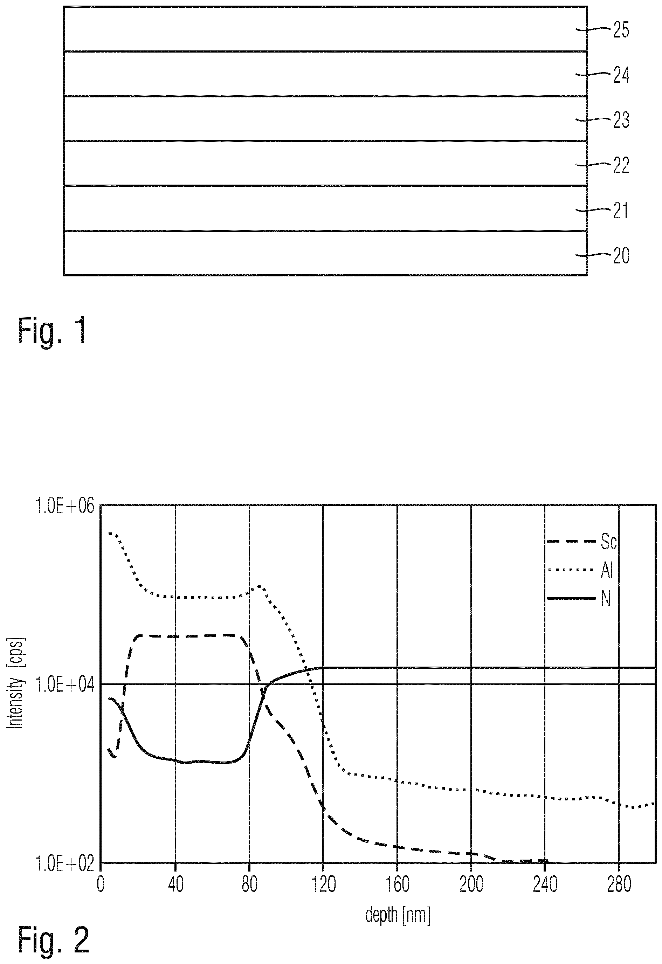

Anhand der Figur 1 wird eine Ausführung eines erfindungsgemäßen Schichtsystems näher erläutert. In anderen Ausführungen kann die Abfolge der Schichten anders gewählt sein, einzelne Schichten können eine andere Zusammensetzung aufweisen, es können zusätzliche Schichten vorhanden sein und/oder einzelne Schichten können auch entfallen.

Das in Figur 1 gezeigte erfindungsgemäße Schichtsystem wird auf einem Wafer bzw. einem Substrat 20 abgeschieden, welches beispielsweise Saphir enthält oder daraus besteht. In anderen Ausführungsformen der Erfindung kann für das Substrat 20 SiC oder AlN oder GaN oder Si oder ein anderes Material verwendet werden. Das Substrat kann ein einkristallines Material enthalten oder daraus bestehen. Das Substrat kann in einigen Ausführungsformen der Erfindung zur Erreichung bestimmter Eigenschaften beschichtet sein, beispielsweise mit Pufferschichten oder mit Passivierungsschichten.

Auf das Substrat 20 wird mittels MOCVD oder MOVPE eine optionale Nukleationsschicht 21 erzeugt, welche GaN enthält oder daraus besteht und welche optional mit Eisen dotiert sein kann. Die Nukleationsschicht kann eine Dicke von etwa 2 $\mu$m aufweisen.

Es folgt eine Pufferschicht 22, welche ebenfalls GaN enthalten oder daraus bestehen kann. Die Pufferschicht kann eine Dicke von etwa 200 nm oder etwa 20 nm bis etwa 50 nm aufweisen.

Schließlich folgt eine optionale heteroepitaktische Schicht 23, welche AlN enthält oder daraus besteht. Darauf wird die erfindungsgemäße Schicht 24 erzeugt, welche $Al_aSc_{1-a}N$ enthält oder daraus besteht, eine Dicke von etwa 20 nm aufweist und deren Gehalt an Scandium (1-a) > 0,01 oder (1-a) > 0,05 oder (1-a) > 0,1 oder (1-a) > 0,2 gewählt ist. Die heteroepitaktische Schicht 23 und die erfindungsgemäße Schicht 24 weisen jeweils eine Wurtzit-Struktur auf, jedoch unterschiedliche Bandlückenenergien.

Den Abschluss bildet ein Cap-layer 25, welcher wiederum GaN oder AlN oder $Si_3N_4$ oder $Al_xGa_{1-x}N$ mit 0.01<x<0.99 enthalten kann. Der Cap-Layer kann eine Dicke von etwa 3 nm oder von etwa 0,1 nm bis etwa 10 nm aufweisen.

Das anhand der Figur 1 dargestellte Schichtsystem ist lediglich beispielhaft zu verstehen. Selbstverständlich sind Abwandlungen möglich, welche sich aus dem konkreten Anwendungszweck ergeben. So können einzelne oder alle Schichten mit optionalen Dotierstoffen versehen werden, um eine vorgebbare elektrische Leitfähigkeit zu erhalten. Darüber hinaus können weitere Schichten eingefügt werden, welche in Figur 1 nicht dargestellt sind oder es können einige der dargestellten Schichten auch entfallen.

Zur Erzeugung von Quantentopfstrukturen kann die Schichtfolge der Schichten 23 und 24 mehrfach wiederholt werden, beispielsweise können zwischen jeweils 1 und jeweils etwa 10 bis etwa 20 oder etwa 15 bis etwa 30 oder etwa 20 bis etwa 50 Schichten 23 und 24 alternierend übereinander abgeschieden werden.

Schließlich können andere Materialien gewählt werden. Beispielsweise kann die Schicht 24 statt AlScN auch AlYN oder GaScN oder GaYN oder InGaScN enthalten. Für die Schicht 23 kann auch GaN oder AlGaN gewählt werden. Das in Figur 1 gezeigte Beispiel soll lediglich zur Erläuterung der Grundidee der Erfindung dienen.

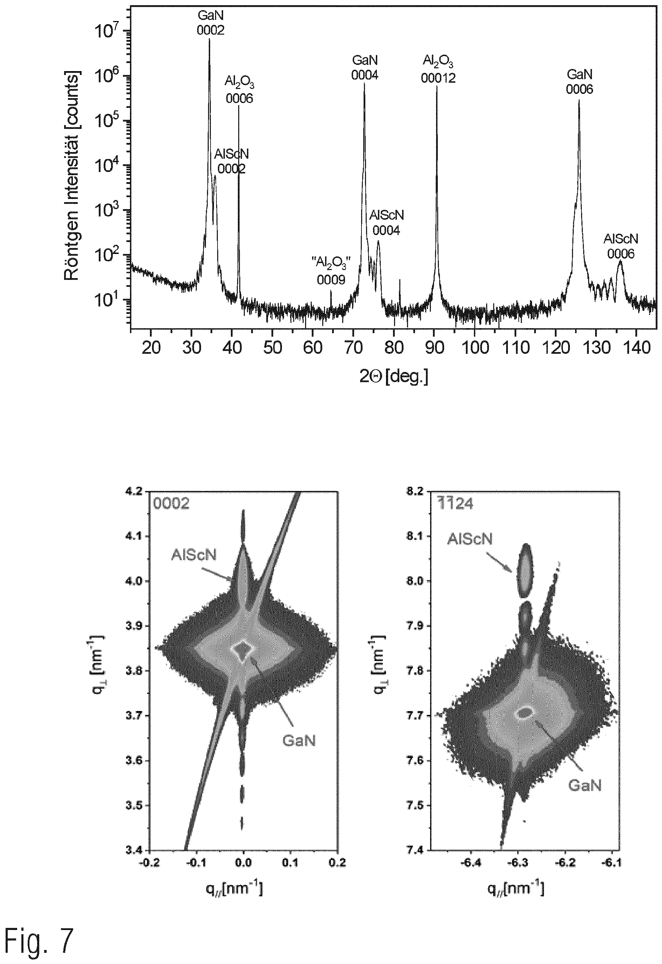

Unter Verwendung einer nachstehend in Zusammenhang mit Figur 7 beschriebenen Vorrichtung wurden die nachfolgend beschriebenen Ausführungsbeispiele durchgeführt, deren Ergebnisse in den Figuren 2 bis 6 veranschaulicht sind.

Epitaktische Wachstumsexperimente zur Abscheidung von $Al_aSc_{1-a}N$- oder $Ga_aSc_{1-a}N$-Schichten in einem Multi-Wafer-MOCVD-Reaktor wurden entweder mit Saphir- oder Siliziumkarbid-Substraten mit einem Durchmesser von 4" (101,6 mm) durchgeführt. Die typische Struktur bestand aus einer 1,5$\mu$m GaN-Epitaxieschicht auf Saphir, gefolgt von einer 50 nm - 150 nm dicken AlScN- oder GaScN-Schicht, die schließlich mit einer wenige nm dicken AlN- oder GaN-Schicht überzogen wurde.

In anderen Ausführungsbeispielen wurden $Al_aSc_{1-a}N$ -Schichten direkt auf eine 50 nm dicke GaN-Schicht aufgebracht, die auf einem $Al_2O_3$-Substrat aufgebracht wurde, um eine hochauflösende Röntgenbeugungsanalyse durchzuführen. Die HRXRD-Messungen wurden mit einer Cu-Strahlungsquelle und einem zweistrahligen Ge(220)-Monochromator durchgeführt, welcher monochromatische Cu-K$\alpha$1-Strahlung liefert. Die Analyse der gebeugten Röntgenstrahlung erfolgte mit einem dreiachsigen Ge(220) Analysator.

In den nachfolgenden Ausführungsbeispielen wird das epitaktische Wachstum von $Al_aSc_{1-a}N$ und $Ga_aSc_{1-a}N$ gezeigt. Verschiedene epitaktische Wachstumsparameter wie Temperatur, Druck, Verhältnis des Molflusses des Prekursors für Stickstoff zum Molfluss der Prekursoren für Al und Sc wurden untersucht. Die Zusammensetzung der AlScN-Schichten wurde mittels Sekundärionen-Massenspektrometrie (SIMS) analysiert, wobei $O^{2+}$- oder $Cs^+$-Ionen mit 5 keV-Energie als primärer Ionenstrahl verwendet wurden, um verschiedene Atome (Sc, Al, Ga, N, C, O, ....) in den epitaktischen Schichten zu identifizieren. Zur Beurteilung der Morphologie dieser Schichten wurde die optische Mikroskopie mit Nomarski-Differentialinterferenzkontrast (NDIC) und Rasterkraftmikroskopie im Tapping-Modus (AFM) eingesetzt.

1. Ausführungsbeispiel

In einem ersten Ausführungsbeispiel wurde ein Schichtsystem nach dem anhand der Figur 1 dargestellten Grundprinzip hergestellt. Das Schichtsystem enthält eine Nukleationsschicht 21, welche GaN enthält, eine Pufferschicht 22, eine heteroepitaktische Schicht 23, welche AlN enthält, eine erfindungsgemäße Schicht 24, welche $Al_aSc_{1-a}N$ enthält und einen Cap-Layer 25, welcher wiederum AlN enthält. In der nachstehenden Tabelle sind die Herstellungsbedingungen für die Nukleationsschicht und den ersten Teil der Pufferschicht nicht angegeben. Für die übrigen Schichten sind in der nachstehenden Tabelle die Wachstumszeit für die jeweilige Schicht, die Substrattemperatur, der Totaldruck in der Reaktionskammer und der Molarfluss der Prekursoren Metallorganika (MO, d.h. die Prekursoren für Ga oder Al), $Cp_3Sc$ (Sc) und $NH_3$ angegeben.

| Schicht | Zeit [h:m:s] | Temp [°C] | Druck [mbar] | MO [mol/min] | Sc [mol/min] | NH3 [mol/min] |
|---|---|---|---|---|---|---|
| GaN (22) | 05:00 | 1180 | 200 | 1,67E-04 | 0 | 3,57E-01 |
| AlN(23) | 03:00 | 1000 | 40 | 2,28E-05 | 0 | 1,52E-02 |
| AlScN | 01:30:00 | 1000 | 40 | 4,87E-06 | 3,60E-06 | 1,52E-02 |
| (24) | | | | | | |
| AlN(25) | 03:00 | 1000 | 40 | 2,28E-05 | 0 | 1,52E-02 |

In Fig. 2 wird das Ergebnis einer SIMS-Messung an dem o.g. Schichtsystem gezeigt. Die erfindungsgemäße Schicht weist einen Sc-Gehalt von 29,5% auf, d.h. die Schicht enthält $Al_{0,705}Sc_{0,295}N$. Diese Konzentration wurde mittels MOCVD bisher noch nicht erhalten und es zeigt sich deutlich, dass es mit dem erfindungsgemäßen Verfahren und der erfindungsgemäßen Vorrichtung gelungen ist, einen hohen molaren Fluss von $Cp_3Sc$ zu erzeugen und in den MOCVD-Reaktor einzuführen. Hierdurch wird erstmals epitaktisches Wachstum von AlScN mittels MOCVD gezeigt.

2. Ausführungsbeispiel

In einem zweiten Ausführungsbeispiel wurde ein Schichtsystem nach dem anhand der Figur 1 dargestellten Grundprinzip hergestellt. Das Schichtsystem enthält zumindest eine Nukleationsschicht 21 und eine Pufferschicht 22, welche jeweils GaN enthalten, eine heteroepitaktische Schicht 23, welche AlN enthält, eine erfindungsgemäße Schicht 24, welche $Al_{0,775}Sc_{0,225}N$ enthält und einen Cap-Layer 25, welcher wiederum AlN enthält. In der nachstehenden Tabelle sind die Herstellungsbedingungen für die Nukleationsschicht und den ersten Teil der Pufferschicht nicht angegeben. Angegeben ist in der nachstehenden Tabelle die Wachstumszeit für die jeweilige Schicht, die Substrattemperatur, der Totaldruck in der Reaktionskammer und der Molarfluss der Prekursoren Metallorganika (MO), $Cp_3Sc$ (Sc) und $NH_3$.

| Schicht | Zeit [h:m:s] | Temp [°C] | Druck [mbar] | MO [mol/min] | Sc [mol/min] | NH3 [mol/min] |
|---|---|---|---|---|---|---|
| GaN (22) | 05:00 | 1180 | 200 | 1,67E-04 | 0 | 3,57E-01 |
| AlN (23) | 03:00 | 1000 | 40 | 1,55E-05 | 0 | 1,52E-02 |
| AlScN (24) | 02:00:00 | 1000 | 40 | 4,87E-06 | 2,49E-06 | 1,52E-02 |
| AlN (25) | 03:00 | 1000 | 40 | 1,55E-05 | 0 | 1,52E-02 |

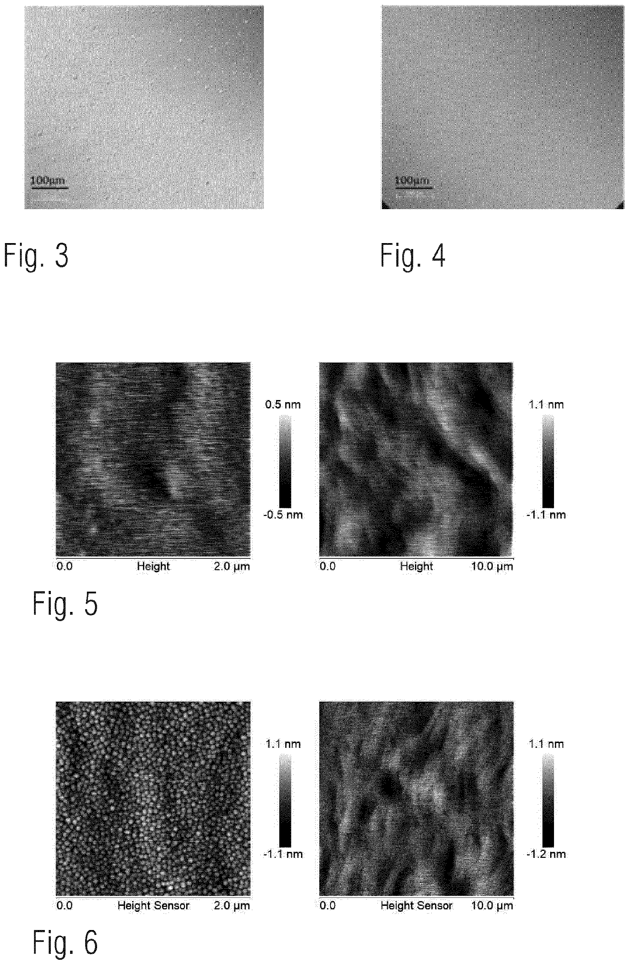

In Figur 3 wird das Ergebnis einer optischen Mikroskopie an der so erhaltenen Schicht gezeigt. Es ist ersichtlich, dass bei einem Sc-Gehalt von 22,5% ($Al_{0,775}Sc_{0,225}N$) eine rissfreie Schicht mit einer Dicke über 100 nm abgeschieden werden konnte.

3. Ausführungsbeispiel

In einem dritten Ausführungsbeispiel wurde ein Schichtsystem nach dem anhand der Figur 1 dargestellten Grundprinzip hergestellt. Das Schichtsystem enthält eine Nukleationsschicht 21 und eine Pufferschicht 22, welche jeweils GaN enthalten, eine heteroepitaktische Schicht 23, welche AlN enthält, eine erfindungsgemäße Schicht 24, welche $Al_{0,8}Sc_{0,2}N$ enthält und einen Cap-Layer 25, welcher wiederum GaN enthält. In der nachstehenden Tabelle sind die Herstellungsbedingungen für die Nukleationsschicht und den ersten Teil der Pufferschicht nicht angegeben. Angegeben ist in der nachstehenden Tabelle die Wachstumszeit für die jeweilige Schicht, die Substrattemperatur, der Totaldruck in der Reaktionskammer und der Molarfluss der Prekursoren Metallorganika (MO), $Cp_3Sc$ (Sc) und $NH_3$.

| Schicht | Zeit [h:m:s] | Temp [°C] | Druck [mbar] | MO [mol/min] | Sc [mol/min] | NH3 [mol/min] |
|---------|--------------|-----------|--------------|--------------|--------------|---------------|
| GaN:Fe (21) | 20:00 | 1180 | 200 | 1,67E-04 | 0 | 3,57E-01 |
| GaN (22) | 40:00 | 1180 | 200 | 1,67E-04 | 0 | 3,57E-01 |
| AlN (23) | 00:30 | 1000 | 40 | 2,28E-05 | 0 | 4,90E-02 |
| AlScN (24) | 23:00 | 1000 | 40 | 4,87E-06 | 3,60E-06 | 4,90E-02 |
| GaN (25) | 00:20 | 1000 | 40 | 4,18E-05 | 0 | 1,78E-01 |

In Figur 4 wird das Ergebnis einer optischen Mikroskopie an der so erhaltenen Schicht gezeigt. Es ist ersichtlich, dass bei einem Sc-Gehalt von 20% ($Al_{0,8}Sc_{0,2}N$) eine rissfreie Schicht mit einer Dicke von 20 nm abgeschieden werden konnte.

4. Ausführungsbeispiel

In einem vierten Ausführungsbeispiel wurde ein Schichtsystem nach dem anhand der Figur 1 dargestellten Grundprinzip hergestellt. Das Schichtsystem enthält zumindest eine Nukleationsschicht 21 und eine Pufferschicht 22, welche jeweils GaN enthalten, (in nachstehender Tabelle ist nur der zweite Teil der Pufferschicht 22 dargestellt), eine heteroepitaktische Schicht 23, welche AlN enthält und eine erfindungsgemäße Schicht 24, welche $Ga_aSc_{1-a}N$ mit a=0,999 enthält. Angegeben ist die Wachstumszeit für die jeweilige Schicht, die Substrattemperatur, der Totaldruck in der Reaktionskammer und der Molarfluss der Prekursoren Metallorganika (MO), $Cp_3Sc$ (Sc) und $NH_3$.

| Schicht | Zeit [h:m:s] | Temp [°C] | Druck [mbar] | MO [mol/min] | Sc [mol/min] | NH3 [mol/min] |
|---------|--------------|-----------|--------------|--------------|--------------|---------------|
| GaN (22) | 05:00 | 1180 | 200 | 1,67E-04 | 0 | 3,57E-01 |
| AlN (23) | 02:00 | 1000 | 40 | 2,28E-05 | 0 | 1,52E-02 |
| GaScN (24) | 02:00:00 | 1000 | 40 | 1,67E-05 | 3,60E-06 | 4,90E-02 |

In Figur 5 wird das Ergebnis einer AFM-Messung gezeigt. Die Messung ergibt eine RMS-Rauheit von 0,33 nm über eine Fläche von 10 $\mu$m x 10 $\mu$m. Auf einer kleineren Fläche von Fläche 2 x 2 $\mu$m$^2$ beträgt die RMS-Rauheit nur 0,15 nm. Die Messungen bestätigen die hohe Kristallqualität der so erhaltenen Schicht. Die Zusammensetzung der erfindungsgemäßen Schicht 24 beträgt $Ga_{0,999}Sc_{0,001}N$.

5. Ausführungsbeispiel

In einem fünften Ausführungsbeispiel wurde ein Schichtsystem nach dem anhand der Figur 1 dargestellten Grundprinzip hergestellt. Die Nukleationsschicht 21 enthält AlN. Die Pufferschicht 22, die heteroepitaktische Schicht 23 und der Cap-Layer 25 entfallen in diesem Beispiel. Die nachstehende Tabelle zeigt die Wachstumsbedingungen für die Nukleationsschicht 21, welche AlN enthält und eine erfindungsgemäße Schicht 24, welche $Al_{0,887}Sc_{0,113}N$ enthält. Angegeben ist jeweils die Wachstumszeit für die jeweilige Schicht, die Substrattemperatur, der Totaldruck in der Reaktionskammer und der Molarfluss der Prekursoren Metallorganika (MO), $Cp_3Sc$ (Sc) und $NH_3$.

| Schicht | Zeit [h:m:s] | Temp [°C] | Druck [mbar] | MO [mol/min] | Sc [mol/min] | NH3 [mol/min] |
|---------|--------------|-----------|--------------|--------------|--------------|---------------|
| AlN (21) | 01:30 | 1000 | 40 | 2,28E-05 | 0 | 1,52E-02 |
| AlScN (24) | 01:30:00 | 1000 | 40 | 4,87E-06 | 1,68E-06 | 1,52E-02 |

Die in Figur 6 wird das Ergebnis einer AFM-Messung gezeigt. Die Messung ergibt eine RMS-Rauheit von 0,33 nm über eine Fläche von 10 $\mu$m x 10 $\mu$m. Auf einer kleineren Fläche von Fläche 2 x 2 $\mu$m$^2$ beträgt die RMS-Rauheit 0,32 nm. Die Messungen bestätigen die hohe Kristallqualität der so erhaltenen Schicht. Die Zusammensetzung der erfindungsgemäßen Schicht 24 beträgt $Al_{0,887}Sc_{0,113}N$.

6. Ausführungsbeispiel

In einem sechsten Ausführungsbeispiel wurde ein Schichtsystem nach dem anhand der Figur 1 dargestellten Grundprinzip auf einem $Al_2O_3$-Substrat hergestellt. Die Nukleationsschicht 21 enthält GaN. Die nachstehende Tabelle zeigt die Wachstumsbedingungen für die Pufferschicht 22, die heteroepitaktische Schicht 23, die erfindungsgemäße Schicht 24, welche $Al_{0,8}Sc_{0,2}N$ enthält den Cap-layer 25, welcher GaN enthält. Die Pufferschicht 22 ist im dargestellten Ausführungsbeispiel aus zwei Schichten zusammengesetzt, wobei die näher am Substrat liegende Teilschicht mit Eisen dotiert ist. Angegeben ist jeweils die Wachstumszeit für die jeweilige Schicht, die Substrattemperatur, der Totaldruck in der Reaktionskammer und der Molarfluss der Prekursoren Metallorganika (MO), $Cp_3Sc$ (Sc) und $NH_3$. Bei der Herstellung der $Al_{0,8}Sc_{0,2}N$-Schicht kommt ein gepulstes Wachstum zur Anwendung, d.h. die Quellen Für Al und Sc werden alternierend geöffnet und geschlossen, so dass zunächst für 5 s Scandium eingeleitet wird und nachfolgend für 2 s Aluminium eingeleitet wird, wobei die Abfolge zyklisch wiederholt wird, bis die Schichtdicke von 12 nm erreicht wird.

| Schicht | Zeit [h:m:s] | Temp [°C] | Druck [mbar] | MO [mol/min] | Sc [mol/min] | NH3 [mol/min] |
|---|---|---|---|---|---|---|
| GaN:Fe (22) | 20:00 | 1180 | 200 | 1,67E-04 | 0 | 3,57E-01 |
| GaN (22) | 40:00 | 1180 | 200 | 1,67E-04 | 0 | 3,57E-01 |
| AlN (23) | 00:30 | 1000 | 40 | 2,28E-05 | 0 | 4,90E-02 |
| AlScN (24) | 23:00 | 1000 | 40 | 4,87E-06 | 3,60E-06 | 4,90E-02 |
| GaN (25) | 00:20 | 1000 | 40 | 4,18E-05 | 0 | 1,78E-01 |

An der so erhaltenen 12 nm $Al_{0,8}Sc_{0,2}N$ Schicht 24 wurde eine HRXRD-Messung (High Resolution X-ray Diffraction) durchgeführt, deren Ergebnis in Figur 7 gezeigt ist. Die Phasenanalyse zeigt, dass reines $Al_{0,8}Sc_{0,2}N$ in Wurtzit-Struktur mit hoher Kristallqualität abgeschieden wurde. Angezeigt wird dies durch das Vorhandensein von Dickenrändern der dünnen AlScN-Schicht für den Reflexionsbereich 0002, 0004 und 0006.

Zur Analyse des Gitterparameters der AlScN-Schicht wurden reziproke Raumabbildungsmessungen (RSMs) der 0002 und 1124 Reflexionsbereiche an derselben Probe durchgeführt. Die geschätzten Gitterparameter für die AlScN-Schicht 24 sind a = 318,21 pm und c = 498,80 pm und für die GaN-Pufferschicht 22 a = 318,21 pm und c = 519,14 pm. Der identische Gitterparameter a der AlScN-Schicht und der GaN-Pufferschicht belegt, dass für die AlScN-Schicht durch MOCVD pseudomorphes Wachstum erreicht wurde. Zusätzlich zeigen sowohl die RSM des 0002- als auch des $\overline{1124}$-Reflexionsbereichs gut aufgelöste Dickenränder, welche die hohe strukturelle Qualität der AlScN-Schicht bestätigen.

7. Ausführungsbeispiel

In einem siebten Ausführungsbeispiel wurde ein Mehrschichtsystem durch ein erfindungsgemäßes MOCVD-Verfahren hergestellt. Das Mehrschichtsystem besteht aus einer Nukleationsschicht 21, die GaN und Eisen als Dotierstoff enthält, einer Pufferschicht 22, die GaN enthält, einer heteroepitaktischen Schicht 23, die AlN enthält, und einer erfindungsgemäßen Schicht 24, die AlScN enthält. Die folgende Tabelle zeigt die bei der Herstellung der Nukleationsschicht 21, der Pufferschicht 22, der heteroepitaktischen Schicht 23 und der Schicht 24 verwendeten Parameter, d.h. die Wachstumszeit, die Substrattemperatur, den Gesamtdruck in der Reaktionskammer und den molaren Fluss der Prekursoren, nämlich Metallorganika (MO, d.h. die Prekursoren für Ga oder Al), Cp3Sc (Scandium) und $NH_3$ für jede der jeweiligen Einzelschichten.

| | Zeit [m:s] | Temp [°C] | Druck [mbar] | flow | MO [mol/min] | Sc [mol/min] | NH$_3$ [mol/min] |
|---|---|---|---|---|---|---|---|
| GaN:Fe | 16:40 | 1180 | 200 | | 1,67E-04 | 0 | 3,57E-01 |
| GaN | 09:20 | 1180 | 200 | | 1,67E-04 | 0 | 3,57E-01 |
| AlN (23) | 01:00 | 1100 | 40 | | 2,28E-05 | 0 | 3,10E-01 |
| ScN (24) | 60:00 | 1100 | 40 | | 0 | 3,60E-06 | 3,10E-01 |

Durch Sekundärionenmassenspektroskopie (SIMS) wurde ein Scandiumgehalt von 95 at.-% in der erfindungsgemäßen Schicht 24 bestätigt, d.h. die erfindungsgemäße Schicht 24 enthält $Al_{0,05}Sc_{0,95}N$. Bei größerer Schichtdicke ist eine weitere Abnahme des Aluminiumgehaltes bis hin zum reinen ScN zu erwarten, da die erfindungsgemäße Schicht 24 nach dem siebten Ausführungsbeispiel nominell ohne Zugabe eines Prekursors für Al erzeugt wurde.

8. Ausführungsbeispiel

In einem achten Ausführungsbeispiel wurde eine erfindungsgemäße Schicht 24 durch ein erfindungsgemäßes MOCVD-Verfahren auf einer Nukleationsschicht 21 hergestellt, welche GaN enthält. Die Pufferschicht 22, die Heteroepitaxieschicht 23 und die Deckschicht 25 werden in diesem Beispiel weggelassen. Die folgende Tabelle zeigt die Wachstumsparameter für die Nukleationsschicht 21 und die erfindungsgemäße Schicht 24, d.h. die Wachstumszeit, die Substrattemperatur, den Gesamtdruck in der Reaktionskammer und den molaren Fluss der Prekursoren, nämlich Metallorganika (MO, d.h. der Prekursoren für Al), $Cp_3Sc$ (der Prekursor für Scandium) und $NH_3$ für jede der beiden Schichten.

| Layer | Zeit [h:m:s] | Temp. [°C] | Druck [mbar] | MO [mol/min] | Sc [mol/min] | $NH_3$ [mol/min] |
|-------|-------------|-----------|-------------|--------------|--------------|-----------------|
| AlN (21) | 00:01:00 | 1200 | 40 | 2.28E-05 | 0 | 3.1E-02 |
| ScN (24) | 09:00:00 | 1200 | 40 | 0 | 3.6E-06 | 3.1E-02 |

Durch Sekundärionenmassenspektroskopie (SIMS) wurde ein Scandiumgehalt von 66 at.-% in der erfindungsgemäßen Schicht 24 bestätigt, d.h. die erfindungsgemäße Schicht 24 enthält $Al_{0,44}Sc_{0,66}N$.

Wie anhand der Ausführungsbeispiele ersichtlich ist, kann mit dem erfindungsgemäßen Verfahren das erfolgreiche epitaktische Wachstum von $Al_aSc_{1-a}N$- und $Ga_aSc_{1-a}N$-Schichten mit 0,05 < a < 0,999 mit hoher kristalliner Qualität und guter Morphologie möglich ist. Dadurch wird es möglich, HEMT-Strukturen oder optoelektronische Bauelemente (Emitter und Detektoren) mit erhöhter Leistungsfähigkeit gegenüber bisheriger nitridbasierter Elektronik herzustellen.

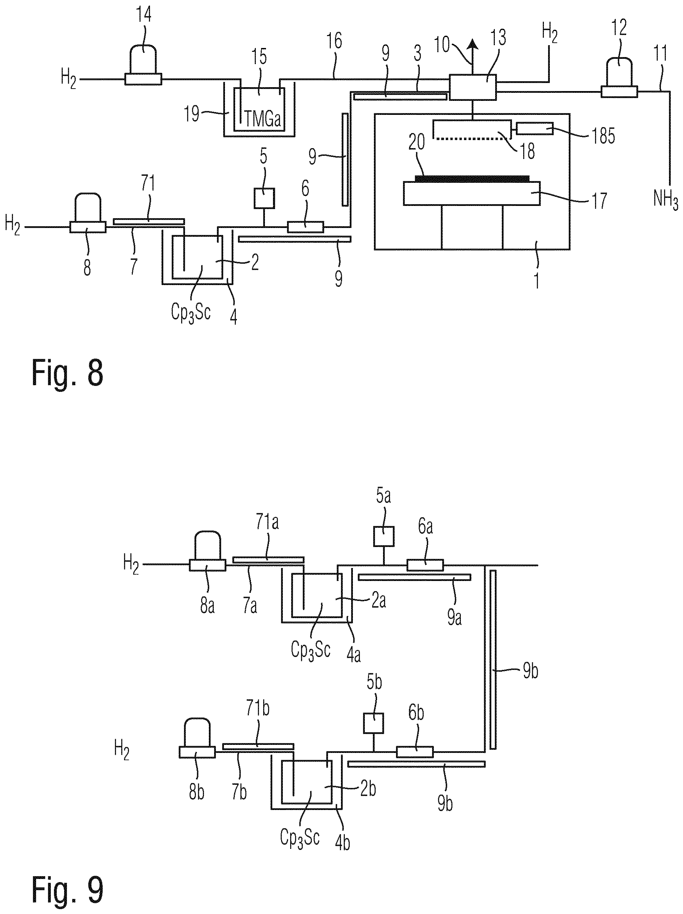

Figur 8 zeigt schematisch eine erfindungsgemäße Vorrichtung in einer ersten Ausführungsform. Anhand dieser Vorrichtung wird auch das erfindungsgemäße Verfahren nochmals näher erläutert. Die Erläuterung der Vorrichtung und des Verfahrens erfolgt exemplarisch an der Verbindung $Al_aSc_{1-a}N$. Die Herstellung anderer Verbindungen kann in analoger Weise erfolgen. Es wird ausdrücklich darauf hingewiesen, dass einzelne hier erläuterte Prozessbedingungen nicht so verstanden werden sollen, dass sie nur in Verbindung mit den anderen Prozessbedingungen zur Durchführung des erfindungsgemäßen Verfahrens geeignet sind.

Die erfindungsgemäße Vorrichtung weist eine Reaktionskammer 1 auf. Die Reaktionskammer kann eine Wandung aus einer Aluminiumlegierung oder einem Edelstahl oder einer Keramik oder Quartz aufweisen. Die Reaktionskammer 1 kann gasdicht ausgeführt sein, um diese mit einer nicht dargestellten Vakuumpumpe zu evakuieren. Die Reaktionskammer kann einen nicht dargestellten Deckel oder eine Öffnung aufweisen, so dass die Reaktionskammer nach Abschluss des Herstellungsverfahrens rasch entladen und mit neuen Substraten beladen werden kann.

In der Reaktionskammer 1 befindet sich zumindest ein Substrathalter 17, welcher zur Aufnahme von zumindest einem Substrat 20 vorgesehen ist. Der Substrathalter 17 kann eine Substratheizung aufweisen, mit welcher das Substrat auf eine Temperatur von etwa 700°C bis etwa 1400°C heizbar ist. In anderen Ausführungsformen oder während bestimmter Verfahrensschritte kann das Substrat auf eine Temperatur von etwa 900°C bis etwa 1300°C geheizt werden. In wiederum anderen Ausführungsformen oder während bestimmter Verfahrensschritte kann das Substrat auf eine Temperatur von etwa 700°C bis etwa 1300°C oder von etwa 1000°C bis etwa 1300°C geheizt werden. Der Substrathalter 17 kann dazu eingerichtet sein, das Substrat in der Reaktionskammer 1 zu bewegen oder zu rotieren, um so einen gleichmäßigen Schichtaufbau der Epitaxieschicht zu ermöglichen. In einigen Ausführungsformen der Erfindung kann der Substrathalter dazu eingerichtet sein, eine Mehrzahl von Substraten aufzunehmen.

Weiterhin befindet sich in der Reaktionskammer 1 zumindest ein Gaseinlass 18. Der Gaseinlass 18 kann in unterschiedlichen Ausführungsformen der Erfindung unterschiedliche Bauformen aufweisen, beispielsweise eine vertikale und/oder eine horizontale Anordnung von Düsen. In einigen Ausführungsformen der Erfindung wird vorgeschlagen, den Gaseinlass 18 mit einer Einlassheizung 185 zu versehen, so dass dieser im Betrieb auf eine Temperatur von mehr als etwa 80°C oder mehr als etwa 90°C mehr als etwa 110°C beheizt werden kann. Die Einlassheizung 185 kann eine Induktionsheizung oder eine Widerstandsheizung enthalten oder der Gaseinlass 18 kann von einem Wärmeträgermedium durchströmt werden, welches thermostatisch geregelt auf einer vorgebbaren Temperatur gehalten wird. Das Wärmeträgermedium kann ausgewählt sein aus Wasser und/oder Glykol oder einem Öl oder einem Heißgas oder Dampf.

Dem Gaseinlass 18 werden gasförmige Prekursoren über eine Sammelleitung 13 zugeführt. In der Sammelleitung 13 kann ein Umschaltventil vorhanden sein, welches dazu eingerichtet ist, alle oder einige Leitungen 3 zur Zufuhr der Prekursoren zeitweise mit einer Abgasleitung 10 und zeitweise mit dem Gaseinlass 18 zu verbinden. Beispielsweise kann durch die Abgasleitung 10 der erste Prekursor aus dem Bubbler 2 als Abgas abgeleitet werden, wenn aufgrund des Schichtaufbaus kein Scandium notwendig ist, weil in der Reaktionskammer 1 gerade eine Schicht hergestellt wird, die kein Scandium enthält.

Die erfindungsgemäße Vorrichtung weist zumindest einen an sich bekannten Bubbler 15 auf, in welchem sich bei Betrieb der Vorrichtung zumindest eine metallorganische Verbindung als dritter Prekursor befindet, beispielsweise Trimethylgallium (TMGa) oder Trimethylaluminium (TMAl). Der Bubbler 15 entspricht in seinem Aufbau einer Gaswaschflasche, d.h. oberhalb des festen oder flüssigen Prekursors bildet sich ein gesättigter Dampf aus, welcher von einem Trägergas aus dem Bubbler 15 ausgetragen und in die Reaktionskammer 1 transportiert wird.

Das Trägergas kann ein Aktivgas oder ein Inertgas sein. In einigen Ausführungsformen kann Wasserstoff oder Stickstoff verwendet werden. Das Trägergas kann mit einem Fluss von etwa 0,01 slm bis etwa 3 slm oder von etwa 5 slm bis etwa 10 slm zugeführt werden. Der Fluss des Trägergases kann mit einem zweiten Massenflussregler 14 konstant gehalten bzw. auf vorgebbare Sollwerte geregelt werden.

Der Bubbler 15 befindet sich in Kontakt mit einer Heiz- oder Kühlvorrichtung 19, welche beispielsweise ein Wasser- oder Ölbad enthalten kann, dessen Temperatur auf einen vorgebbaren Sollwert geregelt wird. Übliche Sollwerte der Temperatur betragen zwischen etwa -5°C bis etwa 50°C. Für TMGa sind Temperaturen von -5 bis 20°C üblich. Für andere Prekursoren, beispielsweise für Al oder In, beträgt die typische Temperatur 10°C bis 20°C. Für Dotierstoffe wie zum Beispiel Mg oder Fe kann eine Temperatur von 15°C bis 50°C gewählt werden.

Der der Reaktionskammer über die Leitung 16 zugeführte Molfluss der Prekursoren kann durch die Temperatur der Heiz- oder Kühlvorrichtung 19 und der Menge des Trägergases beeinflusst werden. Zusätzlich kann der Druck in der Leitung 16 durch einen elektronischen Druckregler kontrolliert werden, welcher in Figur 8 nicht dargestellt ist.

In gleicher Weise wie vorstehend beschrieben, kann eine Mehrzahl gleichartiger Bubbler 15 mit zugeordneten Massenflussreglern und Leitungen vorhanden sein, um unterschiedliche dritte Prekursoren für den Bestandteil $M^1$ oder $M^3$ gleichzeitig oder sequentiell zuzuführen.

Daneben kann der Reaktionskammer Ammoniak als zweiter Prekursor für Stickstoff gasförmig über einen ersten Massenflussregler 12 und die Leitung 11 zugeführt werden. Darüber hinaus kann Wasserstoff und/oder Stickstoff und/oder ein Edelgas als Trägergas oder als Spülgas in die Reaktionskammer eingeleitet werden.

Die erfindungsgemäße Vorrichtung weist weiterhin einen Bubbler 2 auf, der über eine Leitung 3 mit der Reaktionskammer 1 verbunden ist, in der die MOCVD-Abscheidung erfolgt. Im dargestellten Ausführungsbeispiel ist im Bubbler 2 als erster Prekursor für den Sc-Gehalt in der aufzuwachsenden Schicht $Cp_3Sc$ enthalten. Es können aber auch andere erste Prekursoren für $M^2$ im Bubbler 2 enthalten sein, wie vorstehend beschrieben.

Der Bubbler 2 weist eine Heizeinrichtung 4 auf, beispielsweise eine elektrische Widerstandsheizung, eine Induktionsheizung oder ein Wasser- oder Glykol- oder Ölbad. Mit dieser Heizeinrichtung kann die Temperatur im Bubbler 2 geregelt und eingestellt werden, sodass dadurch der molare Fluss von $10^{-6}$ mol/min oder mehr für den Prekursor erreicht wird. In einigen Ausführungsformen der Erfindung beträgt die Temperatur im Bubbler 2 mehr als etwa 90°C oder etwa 120°C bis etwa 200°C oder etwa 150°C bis etwa 200° oder etwa 150°C bis etwa 175°C oder etwa 120°C bis etwa 160°C.

In den Bubbler 2 wird über eine Zufuhrleitung 7 ein Trägergas eingeleitet, beispielsweise Wasserstoff oder Stickstoff oder ein Edelgas. Die Menge des Trägergases beträgt zwischen etwa 1 slm und etwa 15 slm. In anderen Ausführungsformen der Erfindung beträgt die Menge des Trägergases zwischen etwa 1 slm und etwa 6 slm (Standardliter

$$1\,slm = 1,68875\,\frac{Pa \cdot m^3}{s})\,.$$

pro Minute, wobei in SI-Einheiten gilt: Die Menge des Trägergases kann durch einen dritten Massenflussregler 8 gesteuert werden. Der Druck des Trägergases in der Zufuhrleitung 7 kann etwa 1 bar betragen. Das Trägergas wird durch die Zufuhrleitung 7 in den Bubbler 2 mit dem ersten Prekursor geleitet, sodass der Prekursor aus dem Bubbler 2 durch die Leitung 3 ausgetragen und in die Reaktionskammer 1 eingeleitet wird.

Erfindungsgemäß wird vorgeschlagen, die Leitung 3 mit einer ersten Rohrbegleitheizung 9 und optional auch die Zufuhrleitung 7 mit einer zweiten Rohrbegleitheizung 71 zu versehen, welche die jeweiligen Leitungen auf eine erhöhte Temperatur bringen. Hierzu kann beispielsweise eine Induktionsheizung oder eine Widerstandsheizung verwendet werden. Eine Widerstandsheizung kann einen parallel zur Leitung verlaufenden Heizdraht aufweisen und/oder eine metallische Leitung durch direkten Stromfluss erwärmen. Die Leitung 3 und die Zufuhrleitung 7 können auf eine Temperatur gebracht werden, welche in etwa der Temperatur des Bubblers 2 entspricht oder welche bis etwa 50°C höher gewählt ist. Die erste Rohrbegleitheizung 9 kann optional auch das Druckmessgerät 5 und das optionale Ventil 6 beheizen. Hierdurch wird eine unerwünschte Kondensation des ersten Prekursors in der Leitung 3 vermieden oder reduziert.

In der Leitung 3 kann ein Druckmessgerät 5 vorhanden sein, mit dem der Totaldruck in der Leitung 3 und damit innerhalb des Bubblers bestimmt wird. Das Druckmessgerät 5 kann ein gasartunabhängiges Druckmessgerät sein, beispielsweise ein kapazitives Manometer oder ein Federmanometer. Ein solches Druckmessgerät 5 kann ein mechanisches Bauteil sein, welches auch bei erhöhten Temperaturen bis 150°C oder bis 200°C fehlerfrei arbeitet. Der Druck in der Leitung 3 und damit im Bubbler 2 kann etwa 0,15 bar bis 0,3 bar oder 0,17 bar bis 0,26 bar betragen.

Ferner kann die Leitung 3 ein optionales Rückschlagventil 6 aufweisen, mit dem sichergestellt werden kann, dass andere Gase, beispielsweise Trägergas und andere Prekursoren, nicht aus der Reaktionskammer 1 in die Leitung 3 zurückfließen. Ein solches Rückschlagventil 6 kann ein mechanisches Ventil sein, welches im Gegensatz zu elektronischen Druckreglern auch bei erhöhten Temperaturen bis 150°C oder bis 200°C fehlerfrei arbeitet. Dieses Ventil kann auch ein Nadel- oder Dosierventil sein, das manuell oder mit anderen Methoden (elektrisch, pneumatisch oder jede andere geeignete Methode) reguliert werden kann. Dank eines solchen Ventils kann der Gesamtdurchfluss des Gasgemischs (Precursor- und Trägergas) reproduzierbar geregelt werden.

Nach dem Stand der Technik würde der der Reaktionskammer zugeführte Fluss des Prekursors über einen Massenflussregler in der Leitung 3 kontrolliert. Da diese bekannten Massenflussregler für Temperaturen über 50°C nicht geeignet sind, wird erfindungsgemäß vorgeschlagen, den Massenfluss des Trägergases zu regeln und den Druck in der Leitung 3 bzw. im ersten Bubbler 2 sowie dessen Temperatur zu messen. Aus diesen Werten kann der Molarflusses $\dot{n}$ des ersten Prekursors ohne Verwendung eines Massenflussreglers in den beheizten Abschnitten der Leitung 3 bestimmt werden, wie nachstehend dargelegt ist.

Erfindungsgemäß wurde erkannt, dass die Bestimmung des Molarflusses $\dot{n}$ des ersten Prekursors durch folgende Formel erfolgen kann:

$$\dot{n} = \frac{p_{total} \cdot \dot{V} \cdot \frac{p_{sc}}{p_{total}}}{R \cdot T}$$

Hierbei bezeichnet $\dot{V}$ den Fluss des Trägergases $H_2$, $p_{sc}$ den Partialdruck des Scandiums, $p_{total}$ den gemessenen Totaldruck innerhalb des Bubblers, $T$ die Temperatur des Bubblers und $R$ die universelle Gaskonstante. Die Temperatur $T$ des Bubblers und der Fluss $\dot{V}$ des Trägergases kann durch zugeordnete Regeleinrichtungen 8 und 14 kontrolliert werden. Der Partialdruck $p_{sc}$ des Scandiums kann aus der Temperatur $T$ des Bubblers bestimmt werden, wenn für den verwendeten Prekursor die Dampfdruckkurve bekannt ist oder bestimmt wurde. Das Bestimmen der Dampfdruckkurve kann in an sich bekannter Weise experimentell erfolgen oder es können näherungsweise Daten einer ähnlichen Verbindung verwendet werden, beispielsweise $(MeCp)_3Y$. Damit kann auf Druckregler oder Massenflussregler in der Leitung 3 verzichtet werden und gleichwohl lässt sich der Molarflusses $\dot{n}$ des ersten Prekursors bestimmen oder regeln.

Die erfindungsgemäße Vorrichtung ermöglicht somit erstmals den Betrieb eines Bubblers bei Temperaturen von mehr als 50°C, ohne Druckregler oder Massenflussregler in der Leitung 3 aufgrund auftretender Übertemperaturen zu beschädigen. Dadurch können erstmals auch Prekursoren mit niedrigem Dampfdruck in einem MOCVD-Verfahren eingesetzt werden.

Figur 9 zeigt eine erfindungsgemäße Quelle in einer zweiten Ausführungsform, welche einen Molarfluss ($\dot{n}$) von mindestens $10^{-6}$ mol/min für einen Prekursor erzeugen kann. Gleiche Bestandteile der Erfindung sind mit gleichen Bezugszeichen versehen, so dass sich die nachfolgende Beschreibung auf die wesentlichen Unterschiede beschränkt.

Wie aus Figur 9 ersichtlich ist, besteht die Quelle des ersten Prekursors aus einer Mehrzahl von Bubblern, welche gleichzeitig parallel betrieben werden. Im dargestellten Beispiel sind zwei Bubbler 2a und 2b vorhanden, welche jeweils über eine eigene Zufuhrleitung 7a und 7b und eigene zugeordnete Massenflussregler 8a und 8b mit Trägergas versorgt werden. Eine eigene Temperaturregelung über die Heizeinrichtungen 4a und 4b erlaubt eine präzise Kontrolle des jeweils abgegebenen Molarflusses des ersten Prekursors.

In einigen Ausführungsformen der Erfindung kann die Anzahl parallel betriebener Bubbler auch größer sein als 2 und zwischen 2 und etwa 15 oder zwischen 2 und etwa 10 oder zwischen 2 und 6 betragen.

Um den apparativen Aufwand zu verringern, können in einigen Ausführungsformen Komponenten von mehreren Bubblern genutzt werden, beispielsweise können sich mehrere Bubbler 2a und 2b auch in einer einzigen Heizeinrichtung 4 befinden oder von nur einer Zufuhrleitung 7 mit Trägergas versorgt werden.

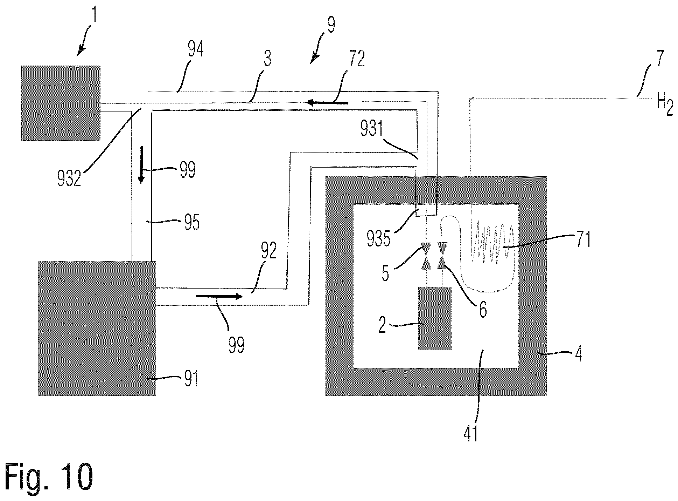

Figur 10 zeigt schematisch eine erfindungsgemäße Vorrichtung in einer zweiten Ausführungsform. Gleiche Bestandteile der Erfindung sind mit gleichen Bezugszeichen versehen, so dass sich die nachfolgende Beschreibung auf die wesentlichen Unterschiede beschränkt.

Nicht dargestellt sind die Quellen bzw. Bubbler für den zweiten und dritten Prekursor, welche ebenso ausgeführt werden können, wie in Figur 8 dargestellt. Ebenso ist die Reaktionskammer 1 nur schematisch dargestellt, ohne die in Zusammenhang mit Figur 8 erläuterten Merkmale nochmals zu wiederholen.

Wie aus Figur 10 ersichtlich ist, ist die Heizeinrichtung 4 für den Bubbler 2 des ersten Prekursors als Wärmeschrank ausgeführt, wobei der Bubbler 2 in den Innenraum 41 des Wärmeschranks eingebracht wird. Der Wärmeschrank kann durch eine elektrische Heizeinrichtung, durch Heißgas oder durch einen festen, flüssigen oder gasförmigen Brennstoff beheizt werden. Die Temperatur kann durch eine nicht dargestellte Steuer- oder Regeleinrichtung auf einen vorgebbaren Wert eingestellt werden.

Im Innenraum 41 des als Heizeinrichtung 4 verwendeten Wärmeschranks befindet sich neben dem Bubbler 2, welcher den ersten Prekursor enthält, ein optionales Rückschlagventil 6 und/oder ein optionales Druckmessgerät 5 oder Teile eines Druckmessgerätes. Hierdurch werden auch diese Komponenten auf der Temperatur des Bubblers 2 gehalten, so dass die Ablagerung des ersten Prekursors vermieden werden kann.

Dem Bubbler 2 wird ein Trägergas, beispielsweise Wasserstoff, über eine Zufuhrleitung 7 und einen optionalen, nicht dargestellten Massenflussregler zugeführt. Der Längsabschnitt der Zufuhrleitung 7, welcher außerhalb des Innenraums 41 verläuft, befindet sich auf Raumtemperatur, so dass die Gaszufuhr des Trägergases in bekannter Weise ausgeführt werden kann und die Handhabung erleichtert ist. Die zweite Rohrbegleitheizung 71, welche zur Erwärmung des Trägergases dient, ist in Form einer Rohrschlange der Zufuhrleitung 7 oder eines Wärmetauschers ausgeführt, welche sich im Innenraum 41 befinden. Hierdurch ist in einfacher Weise sichergestellt, dass die Temperatur des zugeführten Trägergases der Temperatur des ersten Prekursors im Bubbler 2 entspricht. Der erste Prekursor verlässt den Bubbler 2 zusammen mit dem Trägergas über die Leitung 3, wie vorstehend in Zusammenhang mit der ersten Ausführungsform beschrieben und durch den Strömungspfeil 72 verdeutlicht wird.

Die erste Rohrbegleitheizung 9 ist anders als in der ersten Ausführungsform als Rohrleitung 94 ausgestaltet, welche die Leitung 3 umgibt und durch welche bei Betrieb der Vorrichtung ein Wärmeträgermedium 99 strömt. Auf diese Weise ist die Leitung 3 in etwa konzentrisch zur Rohrleitung angeordnet, so dass das Wärmeträgermedium im Zwischenraum strömen und die Leitung homogen erwärmen kann. Dies sichert einen gleichmäßigen Temperaturverlauf der Leitung auch dann, wenn die Leitung 3 aus Material mit schlechter Wärmeleitfähigkeit gefertigt ist, wie beispielsweise Glas oder Kunststoff oder Edelstahl. Sowohl die Leitung 3 für den Prekursor als auch die Rohrleitung 94 des Wärmeträgermediums kann als starres Rohr oder als flexibler Schlauch ausgeführt werden oder abschnittsweise in unterschiedlichen Ausführungen.

Bei Betrieb der Vorrichtung wird in einem Heizelement 91 Wärme erzeugt und dem Wärmeträgermedium 99 zugeführt. Das Heizelement 91 kann weiterhin eine optionale Pumpe enthalten, um das Wärmeträgermedium 99 zu fördern. Das Wärmeträgermedium 99 verlässt das Heizelement 91 durch eine Vorlaufleitung 92. Die Temperatur des Wärmeträgermediums 99 kann so gewählt sein, dass die Temperatur der Leitung 3 in etwa der Temperatur des Bubblers 2 entspricht oder höher ist.

In einigen Ausführungsformen der Erfindung kann das Wärmeträgermedium 99 ausgewählt sein aus Wasser oder Wasserdampf oder einem Thermoöl. In einigen Ausführungsformen der Erfindung kann das Wärmeträgermedium 99 mit einem Druck von etwa 950 mbar bis etwa 1300 mbar in der Rohrleitung strömen. Hierdurch kann der Siedepunkt erhöht sein, so dass im Betrieb höhere Temperaturen erreicht werden können.

Die Vorlaufleitung 92 mündet an einem ersten T-Stück 931. An einem weiteren Anschluss dieses T-Stücks 931 endet ein kurzer Längsabschnitt 935, welcher mit seinem gegenüberliegenden Ende in den Innenraum 41 geführt ist, so dass beim Eintritt der Leitung 3 in die Rohrleitung 94 keine Wärmebrücke entsteht. Die Rohrleitung 94 beginnt schließlich an dem dem kurzen Längsabschnitt 935 gegenüberliegenden Anschluss des ersten T-Stücks 931. Es ist darauf hinzuweisen, dass das erste T-Stück 931 auch innerhalb des Innenraums 41 angeordnet werden kann. In diesem Fall kann der kurze Längsabschnitt 935 auch entfallen bzw. das T-Stück 931 kann als 90°-Bogen ausgeführt werden, in welchen die Leitung 3 durch eine Bohrung in der Wandung eingeführt wird.

Vor der Reaktionskammer 1 befindet sich ein zweites T-Stück 932 in der Rohrleitung 94. Die Leitung 3 ist durch dieses zweite T-Stück 932 im Wesentlichen geradlinig hindurchgeführt. Am abzweigenden Anschluss des zweiten T-Stücks 932 setzt eine Rücklaufleitung 95 an, durch welche das Wärmeträgermedium 99 zum Heizelement 91 zurückgeführt wird.

Selbstverständlich ist die Erfindung nicht auf die in den Figuren dargestellten Ausführungsformen beschränkt. Die vorstehende Beschreibung ist daher nicht als beschränkend, sondern als erläuternd anzusehen. Die nachfolgenden Ansprüche sind so zu verstehen, dass ein genanntes Merkmal in zumindest einer Ausführungsform der Erfindung vorhanden ist. Dies schließt die Anwesenheit weiterer Merkmale nicht aus. Sofern die Beschreibung oder die Ansprüche 'erste' und 'zweite' Merkmale definieren, so dient dies der Unterscheidung gleichartiger Merkmale ohne eine Rangfolge festzulegen.

**Patentansprüche**

1. Verfahren zur Herstellung einer Schicht auf einem Substrat durch metallorganische Gasphasenepitaxie, welche mindestens eine Verbindungen der Formel $M^1_a M^2_{1-a} N$ enthält oder daraus besteht, wobei $M^1$ für ein Element der Gruppe 13 des Periodensystems der Elemente steht und $M^2$ für ein Element der Gruppe 3 oder der Gruppe der Actinoide oder der Gruppe der Lanthanoide des Periodensystems der Elemente stehen und $0,01 \leq a < 0,99$ gewählt ist, **dadurch gekennzeichnet, dass** zumindest zeitweise ein erster Prekursor, welcher $M^2$ enthält oder daraus besteht, mit einem Molarfluss ($\dot{n}$) von mindestens $1 \cdot 10^{-6}$ mol/min in eine Reaktionskammer (1) für die metallorganische Gasphasenepitaxie geleitet wird.

2. Verfahren nach Anspruch 1, **dadurch gekennzeichnet,**
   **dass** $M^1$ ausgewählt ist aus Aluminium oder Indium oder Gallium und/oder
   **dass** der Parameter a so ausgewählt ist, dass
   $0,5 \leq a < 0,95$ oder

$0,5 \leq a \leq 0,90$ oder
$0,7 \leq a \leq 0,95$ oder
$0,7 \leq a \leq 0,9$ oder
$0,5 \leq a \leq 0,8$ gilt und/oder
**dass** $M^1_aM^2_{1-a}N$ ausgewählt ist aus
$Al_aSc_{1-a}N$, $Ga_aSc_{1-a}N$, $Al_aY_{1-a}N$ oder $Al_aEr_{1-a}N$ oder $Ga_aEu_{1-a}N$

3. Verfahren nach einem der Ansprüche 1 oder 2, **dadurch gekennzeichnet, dass** ein Mehrschichtsystem heteroepitaktisch abgeschieden wird, welches zumindest eine Einzelschicht der Zusammensetzung $M^1_aM^2_{1-a}N$ und zumindest eine Einzelschicht eines binären oder ternären Gruppe-13-Nitrides enthält, wobei an deren Grenzfläche ein zweidimensionales Elektronengas ausgebildet wird oder ausbildbar ist.

4. Verfahren nach einem der Ansprüche 1 bis 3, **dadurch gekennzeichnet, dass** der erste Prekursor ein Cyclopentadien enthält oder daraus besteht und/oder dass der erste Prekursor ein Cyclopentadien enthält oder daraus besteht, welches mit C1- bis C5-Alkyl substituiert ist und/oder
dass der Druck in der Reaktionskammer (1) zwischen etwa 40 mbar und etwa 150 mbar oder zwischen etwa 30 mbar und etwa 600 mbar beträgt.

5. Verfahren nach einem der Ansprüche 1 bis 4, **dadurch gekennzeichnet, dass** das Substrat eine Temperatur
von etwa 700°C bis etwa 1400°C oder
von etwa 900°C bis etwa 1300°C oder
von etwa 700°C bis etwa 1300°C oder
von etwa 1000°C bis etwa 1300°C aufweist.

6. Verfahren nach einem der Ansprüche 1 bis 5, **dadurch gekennzeichnet, dass** der erste Prekursor in einem ersten Bubbler (2) vorliegt, aus welchem er in die Reaktionskammer (1) eingeleitet wird, wobei die Temperatur des ersten Bubblers mehr als etwa 90°C oder
etwa 120°C bis etwa 200°C oder
etwa 150°C bis etwa 200°C oder
etwa 150°C bis etwa 175°C oder
etwa 120°C bis etwa 160°C beträgt.

7. Verfahren nach Anspruch 6, **dadurch gekennzeichnet, dass** der erste Bubbler (2) mit der Reaktionskammer (1) über eine Leitung (3) verbunden ist, wobei die Temperatur der Leitung (3) der Temperatur des Bubblers (2) mit einer Abweichung von +0°C bis +50°C entspricht und/oder der Druck in der Leitung (3) etwa 0,15 bar bis etwa 0,3 bar oder etwa 0,17 bar bis etwa 0,26 bar oder zwischen etwa 30 mbar und etwa 600 mbar beträgt.

8. Verfahren nach einem der Ansprüche 6 oder 7, **dadurch gekennzeichnet, dass** dem ersten Bubbler (2) ein Trägergas mit einer Temperatur von mehr als 90°C oder
etwa 120°C bis etwa 200°C oder
etwa 150°C bis etwa 200° oder
etwa 150°C bis etwa 175°C oder
etwa 120°C bis etwa 160°C zugeführt wird.

9. Substrat mit zumindest einer heteroepitaktischen Schicht (23) und zumindest einer Schicht (24), welche zumindest eine Verbindungen der Formel $M^1_aM^2_{1-a}N$ enthält oder daraus besteht, wobei $M^1$ für ein Element der Gruppe 13 des Periodensystems der Elemente und $M^2$ ausgewählt ist aus Scandium oder Yttrium oder Erbium oder Europium und $0,01 \leq a < 0,99$ gewählt ist, wobei zwischen der heteroepitaktischen Schicht (23) und der Schicht (24) eine gradierte Übergangsschicht mit einer Dicke von etwa 10 nm bis etwa 20 nm vorliegt.

10. Substrat nach Anspruch 9, **dadurch gekennzeichnet, dass** die Schicht (24) weiterhin ein Metall $M^3$ enthält, welches aus der der 3. Gruppe oder der 13. Gruppe des Periodensystems gewählt ist, so dass die Schicht mindestens eine Verbindungen der Summenformel $M^1_aM^3_bM^2_{1-a-b}N$ enthält oder daraus besteht, wobei $0,01 \leq a < 0,99$ gewählt ist und $0 \leq b < 0,99$ gewählt ist, wobei $1-a-b > 0$ oder $1-a-b > 0,05$ oder $1-a-b > 0,1$ ist.

11. Vorrichtung zur Herstellung zumindest einer Schicht mittels MOCVD, enthaltend zumindest eine Reaktionskammer (1) und zumindest einen beheizbaren Substrathalter (17) zur Aufnahme des zu beschichtenden Substrates (20) und zumindest einem Gaseinlass (18) **dadurch gekennzeichnet, dass**

die Vorrichtung weiterhin zumindest einen ersten Bubbler (2) enthält, welcher über eine Leitung (3) mit der Reaktionskammer verbunden ist, und weiterhin eine Heizeinrichtung (4) vorhanden ist, mit welcher der Bubbler (2) auf mehr als 90°C oder

etwa 120°C bis etwa 200°C oder

etwa 150°C bis etwa 200°C oder

etwa 150°C bis etwa 175°C oder

etwa 120°C bis etwa 160°C erwärmt werden kann und weiterhin eine Rohrbegleitheizung (9) vorhanden ist, mit welcher die Leitung (3) auf mehr als 90°C oder

etwa 120°C bis etwa 200°C oder

etwa 150°C bis etwa 200°C oder

etwa 150°C bis etwa 175°C oder

etwa 120°C bis etwa 160°C erwärmt werden kann.

12. Vorrichtung nach Anspruch 11, **dadurch gekennzeichnet,**

**dass** in der Leitung (3) zumindest ein Ventil (6) angeordnet ist und/oder

**dass** zumindest ein Druckmessgerät (5) vorhanden ist, welches dazu eingerichtet ist, den Druck in der Leitung (3) zu erfassen.

13. Vorrichtung nach einem der Ansprüche 11 oder 12,

**dadurch gekennzeichnet, dass** der Bubbler mit einer Zufuhrleitung (7) verbunden ist, durch welche ein Trägergas in den Bubbler (2) zuführbar ist und/oder dass in der Zufuhrleitung (7) ein Massenflussregler (8) vorhanden ist und/oder

dass die Zufuhrleitung (7) zwischen dem Massenflussregler (8) und dem Eintritt in den Bubbler (2) beheizbar ist.

14. Vorrichtung nach einem der Ansprüche 11 bis 13, **dadurch gekennzeichnet, dass** die Heizeinrichtung (4) ein Bad enthält oder daraus besteht, in welches ein flüssiges Wärmeträgermedium einfüllbar ist und/oder dass die Heizeinrichtung (4) einen Wärmeschrank enthält oder daraus besteht, in dessen Innenraum (41) der Bubbler (2) einbringbar ist.

15. Vorrichtung nach einem der Ansprüche 11 bis 14, **dadurch gekennzeichnet, dass** die Rohrbegleitheizung (9) zumindest eine Rohrleitung (94) enthält, welche die Leitung (3) umgibt und welche dazu eingerichtet ist, von einem Wärmeträgermedium (99) durchströmt zu werden.

Fig. 1

Fig. 2

Fig. 3

Fig. 4

Fig. 5

Fig. 6

Fig. 7

Fig. 8

Fig. 9

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- CN 108899403 A

**In der Beschreibung aufgeführte Nicht-Patentliteratur**

- **C. SAIDI et al.** Growth of Scandium-doped GaN by MOVPE. *Superlattices and Microstructures,* 2013, vol. 60, 120-128

- **D.D. KOLESKE et al.** *Sandia Report,* 2009